(19) Europäisches Patentamt / European Patent Office / Office européen des brevets

(11) **EP 3 457 400 B1**

(12) **EUROPEAN PATENT SPECIFICATION**

(45) Date of publication and mention of the grant of the patent:
**16.08.2023 Bulletin 2023/33**

(21) Application number: **18202397.8**

(22) Date of filing: **26.11.2013**

(51) International Patent Classification (IPC):
**G10L 19/035** $^{(2013.01)}$ **G10L 19/02** $^{(2013.01)}$

(52) Cooperative Patent Classification (CPC):
**G10L 19/0204; G10L 19/035**

(54) **VOICE AUDIO ENCODING DEVICE, VOICE AUDIO DECODING DEVICE, VOICE AUDIO ENCODING METHOD, AND VOICE AUDIO DECODING METHOD**

STIMMENAUDIOCODIERUNGSVORRICHTUNG, STIMMENAUDIODECODIERUNGSVORRICHTUNG, STIMMENAUDIOCODIERUNGSVERFAHREN UND STIMMENAUDIODECODIERUNGSVERFAHREN

DISPOSITIF DE CODAGE AUDIO VOCAL, DISPOSITIF DE DÉCODAGE AUDIO VOCAL, PROCÉDÉ DE CODAGE AUDIO VOCAL ET PROCÉDÉ DE DÉCODAGE AUDIO VOCAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2012 JP 2012272571**

(43) Date of publication of application:
**20.03.2019 Bulletin 2019/12**

(62) Document number(s) of the earlier application(s) in accordance with Art. 76 EPC:
**17173916.2 / 3 232 437**
**13862073.7 / 2 933 799**

(73) Proprietor: **Fraunhofer-Gesellschaft zur Förderung der angewandten Forschung e.V.**
**80686 München (DE)**

(72) Inventors:
• **LIU, Zongxian**
**Singapore 469332 (SG)**
• **NAGISETTY, Srikanth**
**Singapore 469332 (SG)**
• **OSHIKIRI, Masahiro**
**Osaka-shi, Osaka 540-6207 (JP)**

(74) Representative: **Zinkler, Franz et al**
**Schoppe, Zimmermann, Stöckeler Zinkler, Schenk & Partner mbB Patentanwälte**
**Radlkoferstrasse 2**
**81373 München (DE)**

(56) References cited:
**EP-A2- 0 259 553      US-A1- 2012 004 918**
**US-A1- 2012 290 305      US-B1- 6 393 393**

• **DAVE LINDBERGH POLYCOM INC UNITED STATES: "Draft revised G.722.1 â Low-complexity coding at 24 and 32 kbit/s for hands-free operation in systems with low frame lossâ (for Consent);TD 47 (WP 3/16)", ITU-T DRAFT ; STUDY PERIOD 2005-2008, INTERNATIONAL TELECOMMUNICATION UNION, GENEVA ; CH, vol. 10/16, 8 April 2005 (2005-04-08), pages 1-37, XP017538582, [retrieved on 2006-05-03]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to a speech/audio coding apparatus, a speech/audio decoding apparatus, a speech/audio coding method and a speech/audio decoding method using a transform coding scheme.

Background Art

As a scheme capable of efficiently encoding a speech signal or music signal in a full band (FB) of 0.02 to 20 kHz, there is a technique standardized in ITU-T (International Telecommunication Union Telecommunication Standardization Sector). This technique transforms an input signal into a frequency-domain signal and encodes a band of up to 20 kHz (transform coding).

Here, transform coding is a coding scheme that transforms an input signal from a time domain into a frequency domain using time/frequency transformation such as discrete cosine transform (DCT) or modified discrete cosine transform (MDCT) to enable a signal to be mapped in precise correspondence with auditory characteristics.

In transform coding, a spectral coefficient is split into a plurality of frequency subbands. In coding of each subband, allocating more quantization bits to a band which is perceptually important to human ears makes it possible to improve overall sound quality.

In order to attain this object, studies are being carried out on efficient bit allocation schemes, and for example, a technique disclosed in Non-Patent Literature (hereinafter, referred to as "NPL") 1 is known. Hereinafter, the bit allocation scheme disclosed in Patent Literature (hereinafter, referred to as "PTL") 1 will be described using FIG. 1 and FIG. 2.

FIG. 1 is a block diagram illustrating a configuration of a speech/audio coding apparatus disclosed in PTL 1. An input signal sampled at 48 kHz is inputted to transient detector 11 and transformation section 12 of the speech/audio coding apparatus.

Transient detector 11 detects, from the input signal, either a transient frame corresponding to a leading edge or an end edge of speech or a stationary frame corresponding to a speech section other than that, and transformation section 12 applies, to the frame of the input signal, high-frequency resolution transformation or low-frequency resolution transformation depending on whether the frame detected by transient detector 11 is a transient frame or stationary frame, and acquires a spectral coefficient (or transform coefficient).

Norm estimation section 13 splits the spectral coefficient obtained in transformation section 12 into bands of different bandwidths. Norm estimation section 13 estimates a norm (or energy) of each split band.

Norm quantization section 14 determines a spectral envelope made up of the norms of all bands based on the norm of each band estimated by norm estimation section 13 and quantizes the determined spectral envelope.

Spectrum normalization section 15 normalizes the spectral coefficient obtained by transformation section 12 according to the norm quantized by norm quantization section 14.

Norm adjustment section 16 adjusts the norm quantized by norm quantization section 14 based on adaptive spectral weighting.

Bit allocation section 17 allocates available bits for each band in a frame using the quantization norm adjusted by norm adjustment section 16.

Lattice-vector coding section 18 performs lattice-vector coding on the spectral coefficient normalized by spectrum normalization section 15 using bits allocated for each band by bit allocation section 17.

Noise level adjustment section 19 estimates the level of the spectral coefficient before coding in lattice-vector coding section 18 and encodes the estimated level. A noise level adjustment index is obtained in this way.

Multiplexer 20 multiplexes a frame configuration of the input signal acquired by transformation section 12, that is, a transient signal flag indicating whether the frame is a stationary frame or transient frame, the norm quantized by norm quantization section 14, the lattice coding vector obtained by lattice-vector coding section 18 and the noise level adjustment index obtained by noise level adjustment section 19, and forms a bit stream and transmits the bit stream to a speech/audio decoding apparatus.

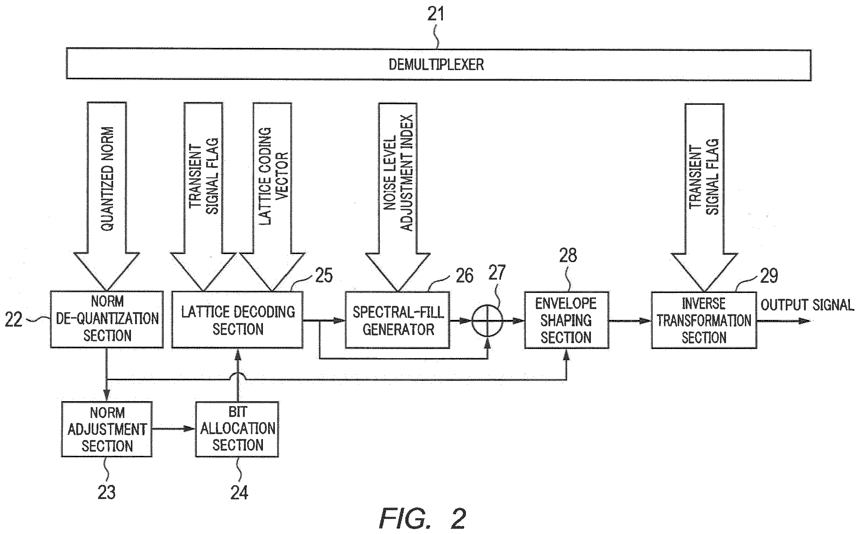

FIG. 2 is a block diagram illustrating a configuration of the speech/audio decoding apparatus disclosed in PTL 1. The speech/audio decoding apparatus receives the bit stream transmitted from the speech/audio coding apparatus and demultiplexer 21 demultiplexes the bit stream.

Norm de-quantization section 22 de-quantizes the quantized norm, acquires a spectral envelope made up of norms of all bands, and norm adjustment section 23 adjusts the norm de-quantized by norm de-quantization section 22 based on adaptive spectral weighting.

Bit allocation section 24 allocates available bits for each band in a frame using the norms adjusted by norm adjustment section 23. That is, bit allocation section 24 recalculates bit allocation indispensable to decode the lattice-vector code of the normalized spectral coefficient.

Lattice decoding section 25 decodes a transient signal flag, decodes the lattice coding vector based on a frame configuration indicated by the decoded transient signal flag and the bits allocated by bit allocation section 24 and acquires a spectral coefficient.

Spectral-fill generator 26 regenerates a low-frequency spectral coefficient to which no bit has been allocated using a codebook created based on the spectral coefficient decoded by lattice decoding section 25. Spectral-fill generator 26 adjusts the level of the spectral coefficient regenerated using a noise level adjustment index. Furthermore, spectral-fill generator 26 regenerates a high-frequency uncoded spectral coefficient using a low-frequency coded spectral coefficient.

Adder 27 adds up the decoded spectral coefficient and the regenerated spectral coefficient, and generates a normalized spectral coefficient.

Envelope shaping section 28 applies the spectral envelope de-quantized by norm de-quantization section 22 to the normalized spectral coefficient generated by adder 27 and generates a full-band spectral coefficient.

Inverse transformation section 29 applies inverse transform such as inverse modified discrete cosine transform (IMDCT) to the full-band spectral coefficient generated by envelope shaping section 28 to transform it into a time-domain signal. Here, inverse transform with high-frequency resolution is applied to a case with a stationary frame and inverse transform with low-frequency resolution is applied to a case with a transient frame.

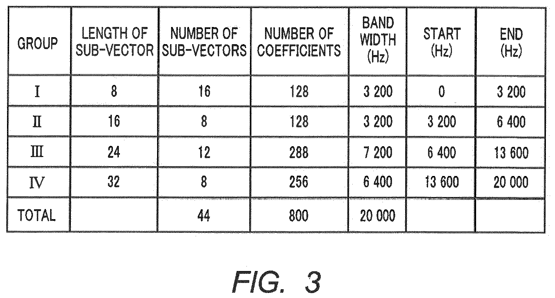

In G.719, the spectral coefficients are split into spectrum groups. Each spectrum group is split into bands of equal length sub-vectors as shown in FIG. 3. Sub-vectors are different in length from one group to another and this length increases as the frequency increases. Regarding transform resolution, higher frequency resolution is used for low frequencies, while lower frequency resolution is used for high frequencies. As described in G.719, the grouping allows an efficient use of the available bit-budget during encoding.

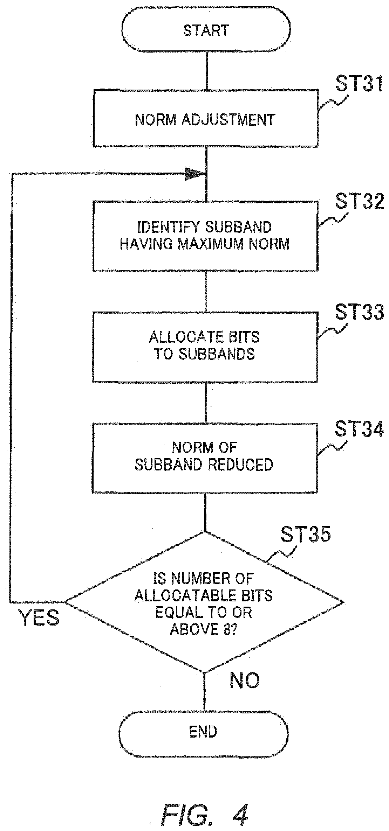

In G.719, the bit allocation scheme is identical in a coding apparatus and a decoding apparatus. Here, the bit allocation scheme will be described using FIG. 4.

As shown in FIG. 4, in step (hereinafter abbreviated as "ST") 31, quantized norms are adjusted prior to bit allocation to adjust psycho-acoustical weighting and masking effects.

In ST32, subbands having a maximum norm are identified from among all subbands and in ST33, one bit is allocated to each spectral coefficient for the subbands having the maximum norm. That is, as many bits as spectral coefficients are allocated.

In ST34, the norms are reduced according to the bits allocated, and in ST35, it is determined whether the remaining number of allocatable bits is 8 or more. When the remaining number of allocatable bits is 8 or more, the flow returns to ST32 and when the remaining number of allocatable bits is less than 8, the bit allocation procedure is terminated.

Thus, in the bit allocation scheme, available bits within a frame are allocated among subbands using the adjusted quantization norms. Normalized spectral coefficients are encoded by lattice-vector coding using the bits allocated to each subband.

Citation List

Patent Literature

NPL 1
ITU-T Recommendation G.719, "Low-complexity full-band audio coding for high-quality conversational applications," ITU-T, 2009.

Summary of Invention

Technical Problem

However, the above bit allocation scheme does not take into consideration input signal characteristics when grouping spectral bands, and therefore has a problem in that efficient bit allocation is not possible and further improvement of sound quality cannot be expected.

US 2012/004918 A1 discloses a scalable audio codec for a processing device that determines first and second bit allocations for each frame of input audio. First bits are allocated for a first frequency band, and second bits are allocated for a second frequency band. The allocations are made on a frame-by-frame basis based on the energy ratio between the two bands. For each frame, the codec transform codes both frequency bands into two sets of transform coefficients, which are then packetized based on the bit allocations. The packets are then transmitted with the processing device. Additionally, the frequency regions of the transform coefficients can be arranged in order of importance determined by power levels and perceptual modeling. Should bit stripping occur, the decoder at a receiving device can produce audio of suitable quality given that bits have been allocated between the bands and the regions of transform coefficients have been ordered by importance.

EP 0 259 553 A2 discloses sub-band speech coders that depend on allocation of available bit capacity of a transmission medium to provide high quality speech coding for digital transmission are well known. One or more bit allocation tables are used to dynamically distribute the channel bit capacity bandwidth among the frequency bands according to the desired output quality of speech rather than by means of complex algorithms or simulation techniques. Multiple bit assignment tables are provided to allow various quality levels to be traded off as increasing bit rate demands are placed upon the transmission system. The technique is used for a single coder to achieve a minimum bit rate for a desired given level of subjective quality in speech output or may be used in a shared bit resource to maintain equal and minimum quality degradation for all users.

Standardization publication "Low Complexity coding at 24 and 32 kbit/s for hands-free operation in systems with low frame loss", TD 47 (WP316), ITU-T Draft Study Period 2005-2008, vol. 10/16 April 8, 2005, pages 1-37 describes a complete text for the revised G.722.1 codec.

An object of the present invention is to provide a speech or audio coding apparatus, a speech or audio decoding apparatus, a speech or audio coding method and a speech or audio decoding method capable of realizing efficient bit allocation and improving sound quality.

This object is achieved by a speech or audio coding apparatus of claim 1, a speech or audio decoding apparatus of claim 18, a speech or audio coding method of claim 21, or a speech or audio decoding method of claim 22.

Advantageous Effects of Invention

According to the present invention, it is possible to realize efficient bit allocation and improve sound quality.

Brief Description of Drawings

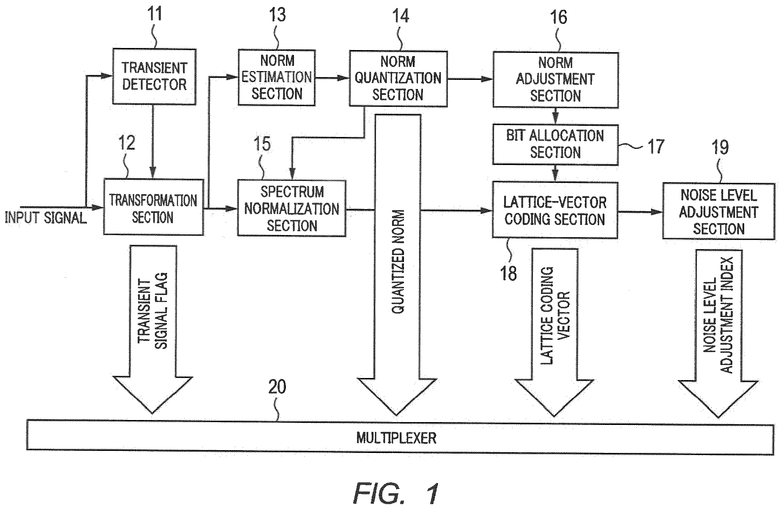

FIG. 1 is a block diagram illustrating a configuration of a speech/audio coding apparatus disclosed in PTL 1;
FIG. 2 is a block diagram illustrating a configuration of a speech/audio decoding apparatus disclosed in PTL 1;
FIG. 3 is a diagram illustrating grouping of spectral coefficients in a stationary mode disclosed in PTL 1;
FIG. 4 is a flowchart illustrating a bit allocation scheme disclosed in PTL 1;
FIG. 5 is a block diagram illustrating a configuration of a speech/audio coding apparatus according to an embodiment of the present invention;
FIG. 6 is a block diagram illustrating a configuration of a speech/audio decoding apparatus according to an embodiment of the present invention;
FIG. 7 is a block diagram illustrating an internal configuration of the bit allocation section shown in FIG. 5 in accordance with an embodiment of the invention;
FIGS. 8A to 8C are diagrams provided for describing a grouping method according to an embodiment of the present invention; and
FIG. 9 is a diagram illustrating a norm variance.

Description of Embodiments

Hereinafter, embodiments of the present invention will be described in detail with reference to the accompanying drawings.

(Embodiment)

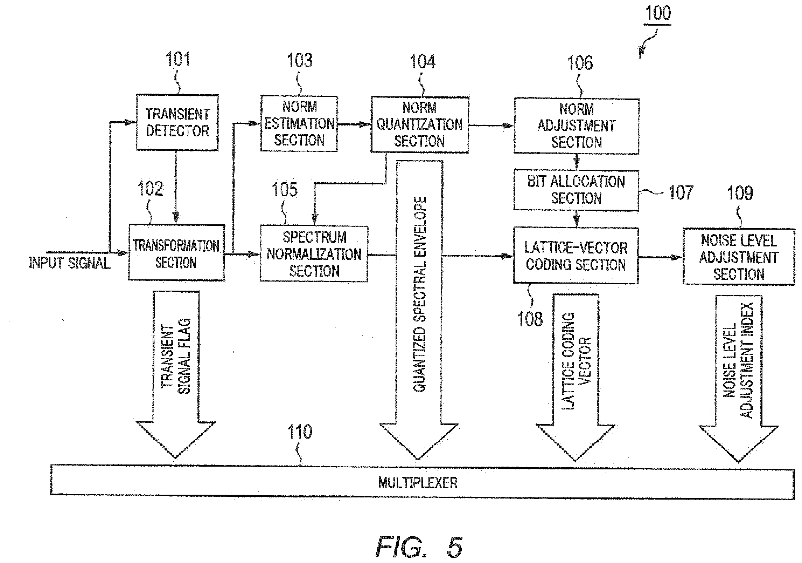

FIG. 5 is a block diagram illustrating a configuration of speech/audio coding apparatus 100 according to an embodiment of the present invention. An input signal sampled at 48 kHz is inputted to transient detector 101 and transformation section 102 of speech/audio coding apparatus 100.

Transient detector 101 detects, from an input signal, either a transient frame corresponding to a leading edge or an end edge of speech or a stationary frame corresponding to a speech section other than that, and outputs the detection result to transformation section 102. Transformation section 102 applies, to the frame of the input signal, high-frequency resolution transformation or low-frequency resolution transformation depending on whether the detection result outputted from transient detector 101 is a transient frame or stationary frame, and acquires a spectral coefficient (or transform coefficient) and outputs the spectral coefficient to norm estimation section 103 and spectrum normalization section 105. Transformation section 102 outputs a frame configuration which is the detection result outputted from transient detector 101, that is, a transient signal flag indicating whether the frame is a stationary frame or a transient frame to multiplexer 110.

Norm estimation section 103 splits the spectral coefficient outputted from transformation section 102 into bands of different bandwidths and estimates a norm (or energy) of each split band. Norm estimation section 103 outputs the estimated norm of each band to norm quantization section 104.

Norm quantization section 104 determines a spectral envelope made up of norms of all bands based on norms of respective bands outputted from norm estimation section 103, quantizes the determined spectral envelope and outputs the quantized spectral envelope to spectrum normalization section 105 and norm adjustment section 106.

Spectrum normalization section 105 normalizes the spectral coefficient outputted from transformation section 102 according to the quantized spectral envelope outputted from norm quantization section 104 and outputs the normalized spectral coefficient to lattice-vector coding section 108.

Norm adjustment section 106 adjusts the quantized spectral envelope outputted from norm quantization section 104 based on adaptive spectral weighting and outputs the adjusted quantized spectral envelope to bit allocation section 107.

Bit allocation section 107 allocates available bits for each band in a frame using the adjusted quantized spectral envelope outputted from norm adjustment section 106 and outputs the allocated bits to lattice-vector coding section 108. Details of bit allocation section 107 will be described later.

Lattice-vector coding section 108 performs lattice-vector coding on the spectral coefficient normalized by spectrum normalization section 105 using the bits allocated for each band in bit allocation section 107 and outputs the lattice coding vector to noise level adjustment section 109 and multiplexer 110.

Noise level adjustment section 109 estimates the level of the spectral coefficient prior to coding in lattice-vector coding section 108 and encodes the estimated level. A noise level adjustment index is determined in this way. The noise level adjustment index is outputted to multiplexer 110.

Multiplexer 110 multiplexes the transient signal flag outputted from transformation section 102, quantized spectral envelope outputted from norm quantization section 104, lattice coding vector outputted from lattice-vector coding section 108 and noise level adjustment index outputted from noise level adjustment section 109, and forms a bit stream and transmits the bit stream to a speech/audio decoding apparatus.

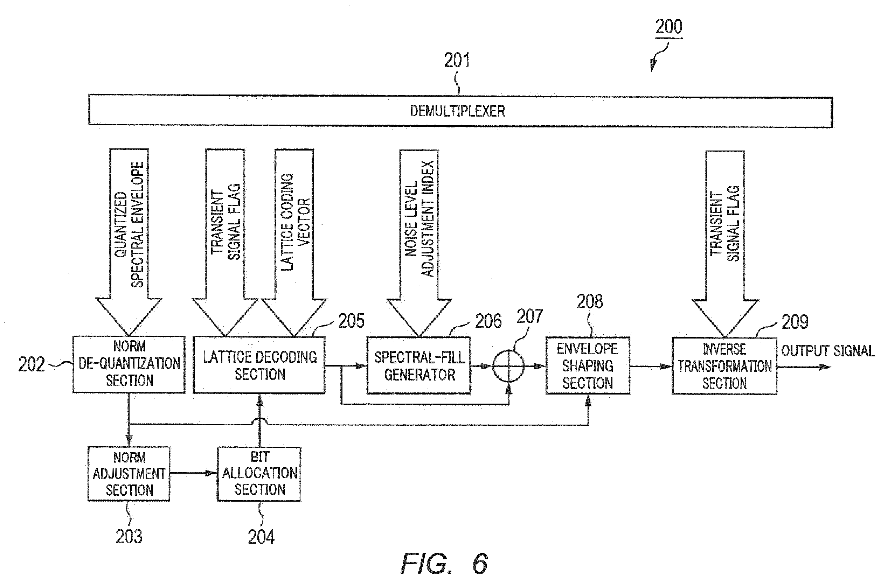

FIG. 6 is a block diagram illustrating a configuration of speech/audio decoding apparatus 200 according to an embodiment of the present invention. A bit stream transmitted from speech/audio coding apparatus 100 is received by speech/audio decoding apparatus 200 and demultiplexed by demultiplexer 201.

Norm de-quantization section 202 de-quantizes the quantized spectral envelope (that is, norm) outputted from the multiplexer, obtains a spectral envelope made up of norms of all bands and outputs the spectral envelope obtained to norm adjustment section 203.

Norm adjustment section 203 adjusts the spectral envelope outputted from norm de-quantization section 202 based on adaptive spectral weighting and outputs the adjusted spectral envelope to bit allocation section 204.

Bit allocation section 204 allocates available bits for each band in a frame using the spectral envelope outputted from norm adjustment section 203. That is, bit allocation section 204 recalculates bit allocation indispensable to decode the lattice-vector code of the normalized spectral coefficient. The allocated bits are outputted to lattice decoding section 205.

Lattice decoding section 205 decodes the lattice coding vector outputted from demultiplexer 201 based on a frame configuration indicated by the transient signal flag outputted from demultiplexer 201 and the bits outputted from bit allocation section 204 and acquires a spectral coefficient. The spectral coefficient is outputted to spectral-fill generator 206 and adder 207.

Spectral-fill generator 206 regenerates a low-frequency spectral coefficient to which no bit has been allocated using a codebook created based on the spectral coefficient outputted from lattice decoding section 205. Spectral-fill generator 206 adjusts the level of the regenerated spectral coefficient using the noise level adjustment index outputted from demultiplexer 201. Furthermore, spectral-fill generator 206 regenerates the spectral coefficient not subjected to high-frequency coding using a low-frequency coded spectral coefficient. The level-adjusted low-frequency spectral coefficient and regenerated high-frequency spectral coefficient are outputted to adder 207.

Adder 207 adds up the spectral coefficient outputted from lattice decoding section 205 and the spectral coefficient outputted from spectral-fill generator 206, generates a normalized spectral coefficient and outputs the normalized spectral coefficient to envelope shaping section 208.

Envelope shaping section 208 applies the spectral envelope outputted from norm de-quantization section 202 to the normalized spectral coefficient generated by adder 207 and generates a full-band spectral coefficient (corresponding to the decoded spectrum). The full-band spectral coefficient generated is outputted to inverse transformation section 209.

Inverse transformation section 209 applies inverse transform such as inverse modified discrete cosine transform (IMDCT) to the full-band spectral coefficient outputted from envelope shaping section 208, transforms it to a time-domain signal and outputs an output signal. Here, inverse transform with high-frequency resolution is applied to a case of a stationary frame and inverse transform with low-frequency resolution is applied to a case of a transient frame.

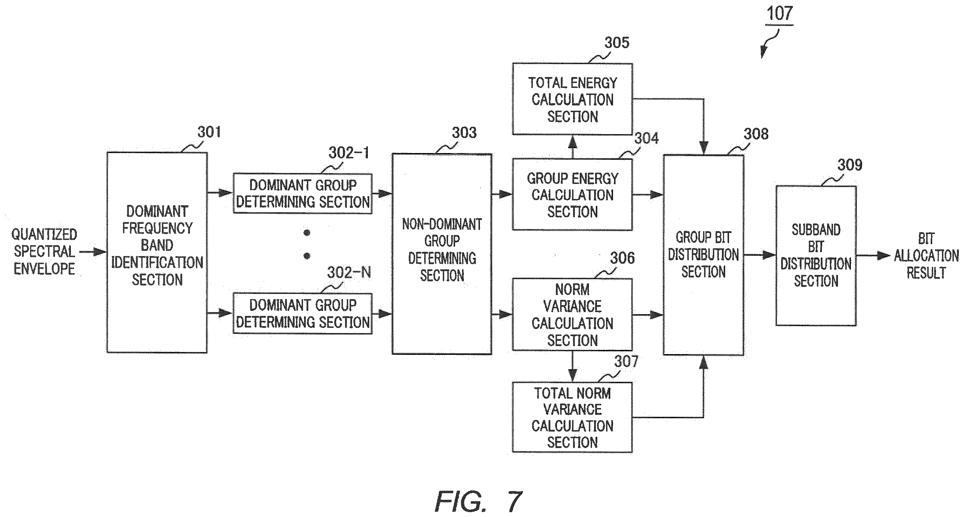

Next, the details of bit allocation section 107 will be described using FIG. 7. Note that bit allocation section 107 of speech/audio coding apparatus 100 is identical in configuration to bit allocation section 204 of speech/audio decoding apparatus 200, and therefore only bit allocation section 107 will be described and description of bit allocation section 204 will be omitted here.

FIG. 7 is a block diagram illustrating an inventive embodiment of an internal configuration of bit allocation section 107 shown in FIG. 5. Dominant frequency band identification section 301 identifies, based on the quantized spectral envelope outputted from norm adjustment section 106, a dominant frequency band which is a subband in which a norm coefficient value in the spectrum has a local maximum value, and outputs each identified dominant frequency band to dominant group determining sections 302-1 to 302N. In addition to designating a frequency band for which a norm coefficient value has a local maximum value, examples of the method of determining a dominant frequency band may include designating, a band among all subbands in which a norm coefficient value has a maximum value as a dominant frequency band or designating as a dominant frequency band, a band having a norm coefficient value exceeding a predetermined threshold or a threshold calculated from norms of all subbands.

Dominant group determining sections 302-1 to 302N adaptively determine group widths according to input signal characteristics centered on the dominant frequency band outputted from dominant frequency band identification section 301. More specifically, the group width is defined as the width of a group of subbands centered on and on both sides of the dominant frequency band up to subbands where a descending slope of the norm coefficient value stops. Dominant group determining sections 302-1 to 302N determine frequency bands included in group widths as dominant groups and output the determined dominant groups to non-dominant group determining section 303. Note that when a dominant frequency band is located at an edge (end of an available frequency), only one side of the descending slope is included in the group.

Non-dominant group determining section 303 determines continuous subbands outputted from dominant group determining sections 302-1 to 302N other than the dominant groups as non-dominant groups without dominant frequency bands. Non-dominant group determining section 303 outputs the dominant groups and the non-dominant groups to group energy calculation section 304 and norm variance calculation section 306.

Group energy calculation section 304 calculates group-specific energy of the dominant groups and the non-dominant groups outputted from non-dominant group determining section 303 and outputs the calculated energy to total energy calculation section 305 and group bit distribution section 308. The group-specific energy is calculated by following equation 1.

[1]

$$Energy(G(k)) = \sum_{i=1}^{M} Norm(i) \quad \dots \text{(Equation 1)}$$

Here, k denotes an index of each group, Energy(G(k)) denotes energy of group k, i denotes a subband index of group 2, M denotes the total number of subbands of group k and Norm(i) denotes a norm coefficient value of subband i of group n.

Total energy calculation section 305 adds up all group-specific energy outputted from group energy calculation section 304 and calculates total energy of all groups. The total energy calculated is outputted to group bit distribution section 308. The total energy is calculated by following equation 2.

[2]

$$Energy_{total} = \sum_{k=1}^{N} Energy(G(k)) \quad \dots \text{(Equation 2)}$$

Here, Energy$_{total}$ denotes total energy of all groups, N denotes the total number of groups in a spectrum, k denotes an index of each group, and Energy(G(k)) denotes energy of group k.

Norm variance calculation section 306 calculates group-specific norm variance for the dominant groups and the non-dominant groups outputted from non-dominant group determining section 303, and outputs the calculated norm variance to total norm variance calculation section 307 and group bit distribution section 308. The group-specific norm variance is calculated by following equation 3.

[3]

$$Norm_{var}(G(k)) = Norm_{max}(G(k)) - Norm_{min}(G(k)) \quad \dots \text{(Equation 3)}$$

Here, k denotes an index of each group, Norm$_{var}$(G(k)) denotes a norm variance of group k, Norm$_{max}$(G(k))

denotes a maximum norm coefficient value of group k, and $Norm_{min}(G(k))$ denotes a minimum norm coefficient value of group k.

Total norm variance calculation section 307 calculates a total norm variance of all groups based on the group-specific norm variance outputted from norm variance calculation section 306. The calculated total norm variance is outputted to group bit distribution section 308. The total norm variance is calculated by following equation 4.

[4]

$$Norm_{vartotal} = \sum_{k=1}^{N} Norm_{var}(G(k)) \quad \ldots(\text{Equation 4})$$

Here, $Norm_{vartotal}$ denotes a total norm variance of all groups, N denotes the total number of groups in a spectrum, k denotes an index of each group, and $Norm_{var}(G(k))$ denotes a norm variance of group k.

Group bit distribution section 308 (corresponding to a first bit allocation section) distributes bits on a group-by-group basis based on group-specific energy outputted from group energy calculation section 304, total energy of all groups outputted from total energy calculation section 305, group-specific norm variance outputted from norm variance calculation section 306 and total norm variance of all groups outputted from total norm variance calculation section 307, and outputs bits distributed on a group-by-group basis to subband bit distribution section 309. Bits distributed on a group-by-group basis are calculated by following equation 5.

[5]

$$Bits(G(k) = Bits_{total} \times \left( scale1 \times \frac{Energy(G(k))}{Energy_{total}} + (1 - scale1) \times \frac{Norm_{var}(G(k))}{Norm_{vartotal}} \right)$$

(Equation 5)

Here, k denotes an index of each group, $Bits(G(k))$ denotes the number of bits distributed to group k, $Bits_{total}$ denotes the total number of available bits, scale1 denotes the ratio of bits allocated by energy, $Energy(G(k))$ denotes energy of group k, $Energy_{total}$ denotes total energy of all groups, and $Normvar(G(k))$ denotes a norm variance of group k.

Furthermore, scale1 in equation 5 above takes on a value within a range of [0, 1] and adjusts the ratio of bits allocated by energy or norm variance. The greater the value of scale 1, the more bits are allocated by energy, and in an extreme case, if the value is 1, all bits are allocated by energy. The smaller the value of scale1, the more bits are allocated by norm variance, and in an extreme case, if the value is 0, all bits are allocated by norm variance.

By distributing bits on a group-by-group basis as described above, group bit distribution section 308 can distribute more bits to dominant groups and distribute fewer bits to non-dominant groups.

Thus, group bit distribution section 308 can determine the perceptual importance of each group by energy and norm variance and enhance dominant groups more. The norm variance matches a masking theory and can determine the perceptual importance more accurately.

Subband bit distribution section 309 (corresponding to a second bit allocation section) distributes bits to subbands in each group based on group-specific bits outputted from group bit distribution section 308 and outputs the bits allocated to group-specific subbands to lattice-vector coding section 108 as the bit allocation result. Here, more bits are distributed to perceptually important subbands and fewer bits are distributed to perceptually less important subbands. Bits distributed to each subband in a group are calculated by following equation 6.

[6]

$$Bits_{G(k)sb(i)} = Bits(G(k)) \times \frac{Norm(i)}{Energy(G(k))} \quad \ldots (\text{Equation 6})$$

Here, $Bits_{G(k)sb(i)}$ denotes a bit allocated to subband i of group k, i denotes a subband index of group k, $Bits_{(G(k))}$ denotes a bit allocated to group k, $Energy(G(k))$ denotes energy of group k, and $Norm(i)$ denotes a norm coefficient value of subband i of group k.

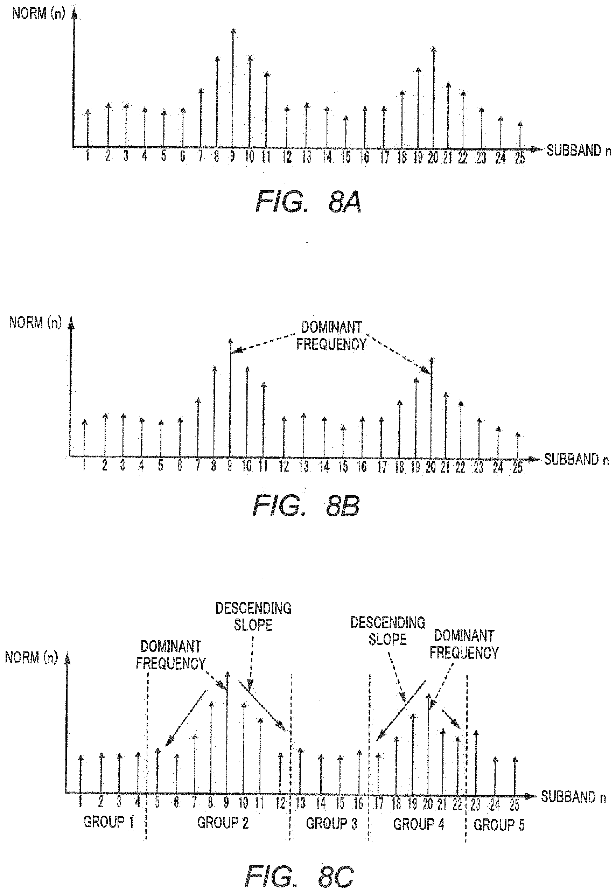

Next, a grouping method in according with an embodiment of the present invention will be described using FIGS. 8A to 8C. Suppose that a quantized spectral envelope shown in FIG. 8A is inputted to peak frequency band identification section 301. Peak frequency band identification section 301 identifies dominant frequency bands 9 and 20 based on the inputted quantized spectral envelope (see FIG. 8B).

Dominant group generation sections 302-1 to 302-N determine subbands centered on and on both sides of dominant frequency bands 9 and 20 up to subbands where a descending slope of the norm coefficient value stops as an identical dominant group. In examples in FIGS. 8A to 8C, as for dominant frequency band 9, subbands 6 to 12 are determined as dominant group (group 2), while as for dominant frequency band 20, subband 17 to 22 are determined as dominant group (group 4) (see FIG. 8C).

Non-dominant group determining section 303 determines continuous frequency bands other than the dominant groups as non-dominant groups without the dominant frequency bands. In the example in FIGS. 8A to 8C, subbands 1 to 5 (group 1), subbands 13 to 16 (group 3) and subbands 23 to 25 (group 5) are determined as non-dominant groups respectively (see FIG. 8C).

As a result, the quantized spectral envelopes are split into five groups, that is, two dominant groups (groups 2 and 4) and three non-dominant groups (groups 1, 3 and 5).

Using such a grouping method, it is possible to adaptively determine group widths according to input signal characteristics. According to this method, the speech/audio decoding apparatus also uses available quantized norm coefficients, and therefore additional information need not be transmitted to the speech/audio decoding apparatus.

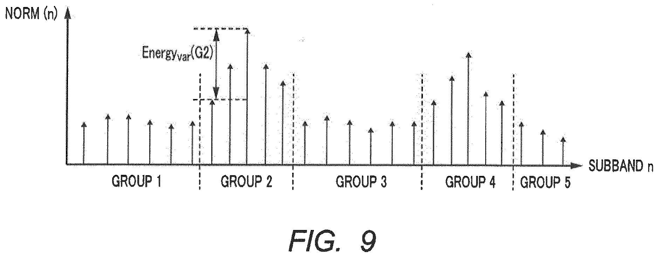

Note that norm variance calculation section 306 calculates a group-specific norm variance. In the examples in FIGS. 8A to 8C, norm variance $Energy_{var}(G(2))$ in group 2 is shown in FIG. 9 as a reference.

Next, the perceptual importance will be described. A spectrum of a speech/audio signal generally includes a plurality of peaks (mountains) and valleys. A peak is made up of a spectrum component located at a dominant frequency of the speech/audio signal (dominant sound component). The peak is perceptually very important. The perceptual importance of the peak can be determined by a difference between energy of the peak and energy of the valley, that is, by a norm variance. Theoretically, when a peak has sufficiently large energy compared to neighboring frequency bands, the peak should be encoded with a sufficient number of bits, but if the peak is encoded with an insufficient number of bits, coding noise that mixes in becomes outstanding, causing sound quality to deteriorate. On the other hand, a valley is not made up of any dominant sound component of a speech/audio signal and is perceptually not important.

According to the frequency band grouping method of the present embodiment, a dominant frequency band corresponds to a peak of a spectrum and grouping frequency bands means separating peaks (dominant groups including dominant frequency bands) from valleys (non-dominant groups without dominant frequency bands).

Group bit distribution section 308 determines perceptual importance of a peak. In contrast to the G.719 technique in which perceptual importance is determined only by energy, the present embodiment determines perceptual importance based on both energy and norm (energy) distributions and determines bits to be distributed to each group based on the determined perceptual importance.

In subband bit distribution section 309, when a norm variance in a group is large, this means that this group is one of peaks, the peak is perceptually more important and a norm coefficient having a maximum value should be accurately encoded. For this reason, more bits are distributed to each subband of this peak. On the other hand, when a norm variance in a group is very small, this means that this group is one of valleys, and the valley is perceptually not important and need not be accurately encoded. For this reason, fewer bits are distributed to each subband of this group.

Thus, the present embodiment identifies a dominant frequency band in which a norm coefficient value in a spectrum of an input speech/audio signal has a local maximum value, groups all subbands into dominant groups including a dominant frequency band and non-dominant groups not including any dominant frequency band, distributes bits to each group based on group-specific energy and norm variances, and further distributes the bits distributed on a group-by-group basis to each subband according to a ratio of a norm to energy of each group. In this way, it is possible to allocate more bits to perceptually important groups and subbands and perform an efficient bit distribution. As a result, sound quality can be improved.

Note that the norm coefficient in the present embodiment represents subband energy and is also referred to as "energy envelope."

Industrial Applicability

The speech/audio coding apparatus, speech/audio decoding apparatus, speech/audio coding method and speech/audio decoding method according to the present invention are applicable to a radio communication terminal apparatus, radio communication base station apparatus, telephone conference terminal apparatus, video conference terminal apparatus and voice over Internet protocol (VoIP) terminal apparatus or the like.

Reference Signs List

    101 Transient detector
    102 Transformation section

103 Norm estimation section
104 Norm quantization section
105 Spectrum normalization section
106, 203 Norm adjustment section
107, 204 Bit allocation section
108 Lattice-vector coding section
109 Noise level adjustment section
110 Multiplexer
201 Demultiplexer
202 Norm de-quantization section
205 Lattice decoding section
206 Spectral-fill generator
207 Adder
208 Envelope shaping section
209 Inverse transformation section
301 Dominant frequency band identification section
302-1 to 302-N Dominant group determining section
303 Non-dominant group determining section
304 Group energy calculation section
305 Total energy calculation section
306 Norm variance calculation section
307 Total norm variance calculation section
308 Group bit distribution section
309 Subband bit distribution section

**Claims**

1. A speech or audio coding apparatus comprising:

   a transformation section (102) configured to transform an input signal from a time domain to a frequency domain;
   an estimation section (103) configured to estimate an energy envelope which represents an energy level for each subband of a plurality of subbands obtained by splitting a frequency spectrum of the input signal;
   a quantization section (104) configured to quantize the energy envelope to obtain a quantized energy envelope comprising quantized subband energies for the plurality of subbands;
   a dominant frequency band identification section (301) configured to identify one or more dominant frequency bands, a dominant frequency band being a subband in which the quantized energy envelope of the frequency spectrum has a local maximum value,
   a group determining section (302-1, 302-N, 303) configured to group the quantized subband energies into a plurality of groups, wherein the group determining section (302-1, 302-N, 303) is configured to adaptively determine group widths of the plurality of groups according to input signal characteristics, and wherein the group determining section (302-1, 302-N, 303) is configured to determine each dominant frequency band and subbands on both sides of the dominant frequency band each forming a descending slope of the quantized energy envelope as a corresponding dominant group and to determine continuous subbands other than the one or more dominant groups as one or more non-dominant groups;
   a first bit allocation section (308) configured to allocate bits to each group of the plurality of groups to obtain a group-specific number of bits for each group of the plurality of groups;
   a second bit allocation section (309) configured to allocate, for each group of the plurality of groups, the group-specific number of bits allocated to a respective group of the plurality of groups to the plurality of subbands belonging to the respective group; and
   a coding section (108) configured to encode, for each subband of the plurality of subbands, the frequency spectrum in the respective subband using bits allocated to the respective subband.

2. The speech or audio coding apparatus according to claim 1, further comprising:

   an energy calculation section (304) configured to calculate a group-specific energy; and
   an energy variance calculation section (306) configured to calculate a group-specific energy variance, wherein the first bit allocation section (308) configured to allocate, based on the calculated group-specific energy and the group-specific energy variance, more bits to a group when at least one of the energy and the energy variance is greater and to allocate fewer bits to a group when at least one of the energy and the energy variance is smaller.

3. The speech or audio coding apparatus according to claim 1, wherein the second bit allocation section (309) is configured to allocate more bits to a subband having a greater energy envelope and allocates fewer bits to a subband having a smaller energy envelope.

4. The speech or audio coding apparatus according to claim 1, wherein the second bit allocation section (309) is configured to allocate more bits to a perceptually more important subband and fewer bits to a perceptually less important subband.

5. The speech or audio coding apparatus according to claim 1, wherein the second bit allocation section (309) is configured to allocate more bits to the subbands in a group having a higher energy variance and to allocate fewer bits to the subbands in a group having a lower energy variance.

6. The speech or audio coding apparatus according to claim 1, wherein the second bit allocation section (309) is configured to allocate more bits to the subbands in a group having a peak in the frequency spectrum and to allocate fewer bits to the subbands in a group having a valley in the frequency spectrum.

7. The speech or audio coding apparatus according to claim 1, wherein the second bit allocation section (309) is configured to operate based on the following equation:

$$Bits_{G(k)sb(i)} = Bits(G(k)) \times \frac{Norm(i)}{Energy(G(k))},$$

wherein $Bits_{G(k)sb(i)}$ denotes a bit allocated to a subband i of a group k, i denotes a subband index of the group k, $Bits_{(G(k))}$ denotes a bit allocated to the group k, Energy(G(k)) denotes an energy of the group k, and Norm(i) denotes a subband energy value of the subband i of the group k.

8. The speech or audio coding apparatus according to claim 1, wherein the first bit allocation section (308) is configured to allocate more bits to a dominant group and fewer bits to a non-dominant group.

9. The speech or audio coding apparatus according to claim 1,
wherein the first bit allocation section (308) is configured to allocate bits on a group-by-group basis based on a group-specific energy calculated by a group energy calculation section (304), a total energy of all groups calculated by a total energy calculation section (305), a group-specific energy variance calculated by a norm variance calculation section (306) and a total energy variance of all groups calculated by a total norm variance calculation section (307).

10. The speech or audio coding apparatus according to claim 9, wherein the first bit allocation section (308) is configured to operate based on the following equation:

$$Bits(G(k) = Bits_{total} \times \left( scale1 \times \frac{Energy(G(k))}{Energy_{total}} + (1 - scale1) \times \frac{Norm_{var}(G(k))}{Norm_{vartotal}} \right),$$

wherein k denotes an index of each group, Bits(G(k)) denotes a number of bits allocated to a group k, $Bits_{total}$ denotes a total number of available bits, scale1 adjusts a ratio of bits allocated by energy, Energy(G(k)) denotes the group-specific energy of the group k, $Energy_{total}$ denotes the total energy of all groups, Normvar(G(k)) denotes the group-specific energy variance of the group k, and $Norm_{vartotal}$ denotes the total energy variance of all groups.

11. The speech or audio coding apparatus according to claim 10, wherein a value of scale1 is between 0 and 1.

12. The speech or audio coding apparatus according to claim 1, wherein the first bit allocation section (308) is configured to determine a perceptual importance of each group by using an energy and an energy variance of the group and to enhance a dominant group more compared to a non-dominant group.

**13.** The speech or audio coding apparatus according to claim 1, wherein the first bit allocation section (308) is configured to determine a perceptual importance of a group based on an energy of the group and an energy distribution and to determine bits to be allocated to each group based on the perceptual importance for the respective group.

**14.** The speech or audio coding apparatus according to claim 1, wherein the group determining section (302-1, 302-N, 303) is configured to include, when a dominant frequency band is located at an end of an available frequency, only one side of the descending slope in the corresponding group.

**15.** The speech or audio coding apparatus according to claim 1, wherein the group determining section (302-1, 302-N, 303) is configured to separate peaks of the frequency spectrum from valleys of the frequency spectrum, wherein a peak of the frequency spectrum is located in a dominant group and a valley of the frequency spectrum is located in a non-dominant group.

**16.** The speech or audio coding apparatus according to claim 1,

wherein the first bit allocation section (308) is configured to allocate bits to a respective group based on an energy of the respective group and an energy variance of the respective group, and
wherein the second bit allocation section (309) is configured to allocate the bits, allocated on a group-by-group basis to the respective group, to a respective subband in the respective group according to a ratio of an energy of the respective subband to an energy of the respective group.

**17.** The speech or audio coding apparatus according to claim 1,

wherein the first bit allocation section (308) is configured to allocate more bits to a perceptually more important group and less bits to a perceptually less important group, and
wherein the second bit allocation section (309) is configured to allocate more bits to a perceptually more important subband and less bits to a perceptually less important subband.

**18.** A speech or audio decoding apparatus comprising:

a de-quantization section (202) configured to de-quantize a quantized spectral envelope comprising quantized subband energies to obtain a de-quantized spectral envelope;
a dominant frequency band identification section (301) configured to identify one or more dominant frequency bands, a dominant frequency band being a subband in which the quantized energy envelope of the frequency spectrum has a local maximum value;
a group determining section (302-1, 302-N, 303) configured to group the quantized subband energies into a plurality of groups, wherein the group determining section (302-1, 302-N, 303) is configured to adaptively determine group widths of the plurality of groups according to input signal characteristics, and wherein the group determining section (302-1, 302-N, 303) is configured to determine each dominant frequency band and subbands on both sides of the dominant frequency band each forming a descending slope of the quantized energy envelope as a corresponding dominant group and to determine continuous subbands other than the one or more dominant groups as one or more non-dominant groups;
a first bit allocation section (308) configured to allocate bits to each group of the plurality of groups to obtain a group-specific number of bits for each group of the plurality of groups;
a second bit allocation section (309) configured to allocate, for each group of the plurality of groups, the group-specific number of bits allocated to a respective group of the plurality of groups to a plurality of subbands belonging to the respective group;
a decoding section (205) configured to decode, for each subband of the plurality of subbands, a frequency spectrum of a speech or audio signal using the bits allocated to the respective subband to obtain a decoded frequency spectrum;
an envelope shaping section (208) configured to apply the de-quantized spectral envelope to the decoded frequency spectrum and to reproduce a decoded spectrum; and
an inverse transformation section (209) configured to inversely transform the decoded spectrum from a frequency domain to a time domain.

**19.** The speech or audio decoding apparatus according to claim 18, further comprising:

an energy calculation section (304) configured to calculate a group-specific energy; and

an energy variance calculation section (306) configured to calculate a group-specific energy variance, wherein the first bit allocation section (308) is configured to allocate, based on the calculated group-specific energy and the group-specific energy variance, more bits to a group when at least one of the energy and the energy variance is greater and to allocate fewer bits to a group when at least one of the energy and the energy variance is smaller.

20. The speech or audio decoding apparatus according to claim 18, wherein the second bit allocation section (309) is configured to allocate more bits to a subband having a greater energy envelope and to allocate fewer bits to a subband having a smaller energy envelope.

21. A speech or audio coding method comprising:

transforming an input signal from a time domain to a frequency domain;
estimating an energy envelope that represents an energy level for each subband of a plurality of subbands obtained by splitting a frequency spectrum of the input signal;
quantizing the energy envelope to obtain a quantized energy envelope comprising quantized subband energies for a plurality of subbands;
identifying one or more dominant frequency bands, a dominant frequency band being a subband in which the quantized energy envelope of the frequency spectrum has a local maximum value;
grouping the quantized subband energies for the plurality of subbands into a plurality of groups, each group having a plurality of at least two subbands, wherein the grouping comprises adaptively determining group widths of the plurality of groups according to input signal characteristics, determining each dominant frequency band and subbands on both sides of the dominant frequency band each forming a descending slope of the quantized energy envelope as a corresponding dominant group, and determining continuous subbands other than the one or more dominant groups as one or more non-dominant groups;
allocating, for each group of the plurality of groups, bits to each group of the plurality of groups to obtain a group-specific number of bits for each group of the plurality of groups;
allocating, for each group of the plurality of groups, the group-specific number of bits allocated to a respective group of the plurality of groups to the plurality of subbands belonging to the respective group; and
encoding, for each subband of the plurality of subbands, the frequency spectrum included in the respective subband using bits allocated to the respective subband.

22. A speech or audio decoding method comprising:

de-quantizing a quantized spectral envelope comprising quantized subband energies to obtain a de-quantized spectral envelope;
identifying one or more dominant frequency bands, a dominant frequency band being a subband in which the quantized energy envelope of the frequency spectrum has a local maximum value;
grouping the quantized subband energies into a plurality of groups, wherein the grouping comprises adaptively determining group widths of the plurality of groups according to input signal characteristics, determining each dominant frequency band and subbands on both sides of the dominant frequency band each forming a descending slope of the quantized energy envelope as a corresponding dominant group, and determining continuous subbands other than the one or more dominant groups as one or more non-dominant groups;
allocating, for each group of the plurality of groups, bits to each group of the plurality of groups to obtain a group-specific number of bits for each group of the plurality of groups;
allocating, for each group of the plurality of groups, the group-specific number of bits allocated to a respective group of the plurality of groups to a plurality of subbands belonging to the respective group;
decoding, for each subband of the plurality of subbands, a frequency spectrum of a speech or audio signal using the bits allocated to the respective subband to obtain a decoded frequency spectrum;
applying the de-quantized spectral envelope to the decoded frequency spectrum and reproducing a decoded spectrum; and
inversely transforming the decoded spectrum from a frequency domain to a time domain.

23. Radio communication terminal apparatus, radio communication base station apparatus, telephone conference terminal apparatus, video conference terminal apparatus, or voice over Internet protocol (VoIP) terminal apparatus comprising a speech or audio coding apparatus of claim 1, or a speech or audio decoding apparatus of claim 18.

**Patentansprüche**

1. Eine Sprach- oder Audiocodiervorrichtung, die folgende Merkmale aufweist:

   einen Transformationsabschnitt (102), der konfiguriert ist, ein Eingangssignal von einem Zeitbereich in einen Frequenzbereich zu transformieren;
   einen Schätzabschnitt (103), der konfiguriert ist, eine Energiehüllkurve zu schätzen, die einen Energiepegel für jedes Teilband einer Mehrzahl von Teilbändern darstellt, die durch Teilen eines Frequenzspektrums des Eingangssignals erhalten werden;
   einen Quantisierungsabschnitt (104), der konfiguriert ist, die Energiehüllkurve zu quantisieren, um eine quantisierte Energiehüllkurve zu erhalten, die quantisierte Teilbandenergien für die Mehrzahl von Teilbändern aufweist;
   einen Dominantes-Frequenzband-Identifizierungsabschnitt (301), der konfiguriert ist, ein oder mehrere dominante Frequenzbänder zu identifizieren, wobei ein dominantes Frequenzband ein Teilband ist, in dem die quantisierte Energiehüllkurve des Frequenzspektrums einen lokalen Maximalwert aufweist,
   einen Gruppenbestimmungsabschnitt (302-1, 302-N, 303), der konfiguriert ist, die quantisierten Teilbandenergien in eine Mehrzahl von Gruppen zu gruppieren, wobei der Gruppenbestimmungsabschnitt (302-1, 302-N, 303) konfiguriert ist, Gruppenbreiten der Mehrzahl von Gruppen gemäß Eingangssignalcharakteristika adaptiv zu bestimmen, und wobei der Gruppenbestimmungsabschnitt (302-1, 302-N, 303) konfiguriert ist, jedes dominante Frequenzband und Teilbänder auf beiden Seiten des dominanten Frequenzbands, die jeweils eine absteigende Neigung der quantisierten Energiehüllkurve bilden, als eine entsprechende dominante Gruppe zu bestimmen, und andere kontinuierliche Teilbänder als die eine oder mehreren dominanten Gruppen als eine oder mehrere nicht dominante Gruppen zu bestimmen;
   einen ersten Bitzuordnungsabschnitt (308), der konfiguriert ist, jeder Gruppe der Mehrzahl von Gruppen Bits zuzuordnen, um für jede Gruppe der Mehrzahl von Gruppen eine gruppenspezifische Anzahl von Bits zu erhalten;
   einen zweiten Bitzuordnungsabschnitt (309), der konfiguriert ist, für jede Gruppe der Mehrzahl von Gruppen die gruppenspezifische Anzahl von Bits, die einer jeweiligen Gruppe der Mehrzahl von Gruppen zugeordnet sind, der Mehrzahl von Teilbändern zuzuordnen, die zu der jeweiligen Gruppe gehören; und
   einen Codierabschnitt (108), der konfiguriert ist, für jedes Teilband der Mehrzahl von Teilbändern das Frequenzspektrum in dem jeweiligen Teilband unter Verwendung von Bits zu codieren, die dem jeweiligen Teilband zugeordnet sind.

2. Die Sprach- oder Audiocodiervorrichtung gemäß Anspruch 1, die ferner folgende Merkmale aufweist:

   einen Energieberechnungsabschnitt (304), der konfiguriert ist, eine gruppenspezifische Energie zu berechnen; und
   einen Energievarianzberechnungsabschnitt (306), der konfiguriert ist, eine gruppenspezifische Energievarianz zu berechnen, wobei
   der erste Bitzuordnungsabschnitt (308) konfiguriert ist, basierend auf der berechneten gruppenspezifischen Energie und der gruppenspezifischen Energievarianz einer Gruppe mehr Bits zuzuordnen, wenn zumindest eine der Energie und der Energievarianz größer ist, und einer Gruppe weniger Bits zuzuordnen, wenn zumindest eine der Energie und der Energievarianz geringer ist.

3. Die Sprach- oder Audiocodiervorrichtung gemäß Anspruch 1, bei der der zweite Bitzuordnungsabschnitt (309) konfiguriert ist, einem Teilband mit einer größeren Energiehüllkurve mehr Bits zuzuordnen und einem Teilband mit einer kleineren Energiehüllkurve weniger Bits zuzuordnen.

4. Die Sprach- oder Audiocodiervorrichtung gemäß Anspruch 1, bei der der zweite Bitzuordnungsabschnitt (309) konfiguriert ist, einem wahrnehmungsmäßig wichtigeren Teilband mehr Bits und einem wahrnehmungsmäßig weniger wichtigen Teilband weniger Bits zuzuordnen.

5. Die Sprach- oder Audiocodiervorrichtung gemäß Anspruch 1, bei der der zweite Bitzuordnungsabschnitt (309) konfiguriert ist, den Teilbändern in einer Gruppe mit einer höheren Energievarianz mehr Bits zuzuordnen und den Teilbändern in einer Gruppe mit einer geringeren Energievarianz weniger Bits zuzuordnen.

6. Die Sprach- oder Audiocodiervorrichtung gemäß Anspruch 1, bei der der zweite Bitzuordnungsabschnitt (309) konfiguriert ist, den Teilbändern in einer Gruppe, die eine Spitze in dem Frequenzspektrum aufweisen, mehr Bits zuzuordnen, und den Teilbändern in einer Gruppe, die einen Tal in dem Frequenzspektrum aufweisen, weniger Bits zuzuordnen.

7. Die Sprach- oder Audiocodiervorrichtung gemäß Anspruch 1, bei der der zweite Bitzuordnungsabschnitt (309) konfiguriert ist, basierend auf der folgenden Gleichung zu arbeiten:

$$Bits_{G(k)sb(i)} = Bits(G(k)) \times \frac{Norm(i)}{Energy(G(k))},$$

wobei $Bits_{G(k)sb(i)}$ ein Bit bezeichnet, das einem Teilband i einer Gruppe k zugeordnet ist, i einen Teilbandindex der Gruppe k bezeichnet, $Bits_{(G(k))}$ ein Bit bezeichnet, das der Gruppe k zugeordnet ist, Energy(G(k)) eine Energie der Gruppe k bezeichnet und Norm(i) einen Teilbandenergiewert des Teilbands i der Gruppe k bezeichnet.

8. Die Sprach- oder Audiocodiervorrichtung gemäß Anspruch 1, bei der der erste Bitzuordnungsabschnitt (308) konfiguriert ist, einer dominanten Gruppe mehr Bits und einer nicht dominanten Gruppe weniger Bits zuzuordnen.

9. Die Sprach- oder Audiocodiervorrichtung gemäß Anspruch 1, bei der der erste Bitzuordnungsabschnitt (308) konfiguriert ist, Bits auf einer gruppenweisen Basis zuzuordnen, basierend auf einer gruppenspezifischen Energie, die durch einen Gruppenenergieberechnungsabschnitt (304) berechnet wird, einer Gesamtenergie aller Gruppen, die durch einen Gesamtenergieberechnungsabschnitt (305) berechnet wird, einer gruppenspezifischen Energievarianz, die durch einen Normvarianzberechnungsabschnitt (306) berechnet wird, und einer Gesamtenergievarianz aller Gruppen, die durch einen Gesamtnormvarianzberechnungsabschnitt (307) berechnet wird.

10. Die Sprach- oder Audiocodiervorrichtung gemäß Anspruch 9, bei der der erste Bitzuordnungsabschnitt (308) konfiguriert ist, basierend auf der folgenden Gleichung zu arbeiten:

$$Bits(G(k) = Bits_{total} \times \left( scale1 \times \frac{Energy(G(k))}{Energy_{total}} + (1 - scale1) \times \frac{Norm_{var}(G(k))}{Norm_{var\,total}} \right),$$

wobei k einen Index jeder Gruppe bezeichnet, Bits(G(k)) eine Anzahl von Bits bezeichnet, die einer Gruppe k zugeordnet sind, $Bits_{total}$ eine Gesamtzahl von verfügbaren Bits bezeichnet, scale1 ein Verhältnis von Bits einstellt, die durch Energie zugeordnet sind, Energy(G(k)) die gruppenspezifische Energie der Gruppe k bezeichnet, $Energy_{total}$ die Gesamtenergie aller Gruppen bezeichnet, $Norm_{var}(G(k))$ die gruppenspezifische Energievarianz der Gruppe k bezeichnet und $Norm_{var\,total}$ die Gesamtenergievarianz aller Gruppen bezeichnet.

11. Die Sprach- oder Audiocodiervorrichtung gemäß Anspruch 10, bei der ein Wert von scale1 zwischen 0 und 1 liegt.

12. Die Sprach- oder Audiocodiervorrichtung gemäß Anspruch 1, bei der der erste Bitzuordnungsabschnitt (308) konfiguriert ist, eine Wahrnehmungsbedeutung jeder Gruppe durch Verwenden einer Energie und einer Energievarianz der Gruppe zu bestimmen, und eine dominante Gruppe im Vergleich zu einer nicht dominanten Gruppe stärker zu verstärken.

13. Die Sprach- oder Audiocodiervorrichtung gemäß Anspruch 1, bei der der erste Bitzuordnungsabschnitt (308) konfiguriert ist, eine Wahrnehmungsbedeutung einer Gruppe basierend auf einer Energie der Gruppe und einer Energieverteilung zu bestimmen, und basierend auf der Wahrnehmungsbedeutung für die jeweilige Gruppe Bits zu bestimmen, die jeder Gruppe zuzuordnen sind.

14. Die Sprach- oder Audiocodiervorrichtung gemäß Anspruch 1, bei der der Gruppenbestimmungsabschnitt (302-1, 302-N, 303) konfiguriert ist, wenn sich ein dominantes Frequenzband an einem Ende einer verfügbaren Frequenz befindet, nur eine Seite der absteigenden Neigung in die entsprechende Gruppe aufzunehmen.

15. Die Sprach- oder Audiocodiervorrichtung gemäß Anspruch 1, bei der der Gruppenbestimmungsabschnitt (302-1, 302-N, 303) konfiguriert ist, Spitzen des Frequenzspektrums von Tälern des Frequenzspektrums zu trennen, wobei eine Spitze des Frequenzspektrums sich in einer dominanten Gruppe befindet und ein Tal des Frequenzspektrums sich in einer nicht dominanten Gruppe befindet.

**16.** Die Sprach- oder Audiocodiervorrichtung gemäß Anspruch 1,

bei der der erste Bitzuordnungsabschnitt (308) konfiguriert ist, Bits einer jeweiligen Gruppe zuzuordnen, basierend auf einer Energie der jeweiligen Gruppe und einer Energievarianz der jeweiligen Gruppe, und wobei der zweite Bitzuordnungsabschnitt (309) konfiguriert ist, die Bits, die auf einer gruppenweisen Basis der jeweiligen Gruppe zugeordnet sind, einem jeweiligen Teilband in der jeweiligen Gruppe zuzuordnen, gemäß einem Verhältnis einer Energie des jeweiligen Teilbands zu einer Energie der jeweiligen Gruppe.

**17.** Die Sprach- oder Audiocodiervorrichtung gemäß Anspruch 1,

bei der der erste Bitzuordnungsabschnitt (308) konfiguriert ist, einer wahrnehmungsmäßig wichtigeren Gruppe mehr Bits und einer wahrnehmungsmäßig weniger wichtigen Gruppe weniger Bits zuzuordnen, und wobei der zweite Bitzuordnungsabschnitt (309) konfiguriert ist, einem wahrnehmungsmäßig wichtigeren Teilband mehr Bits und einem wahrnehmungsmäßig weniger wichtigen Teilband weniger Bits zuzuordnen.

**18.** Eine Sprach- oder Audiodecodiervorrichtung, die folgende Merkmale aufweist:

einen Dequantisierungsabschnitt (202), der konfiguriert ist, eine quantisierte spektrale Hüllkurve, die quantisierte Teilbandenergien aufweist, zu dequantisieren, um eine dequantisierte spektrale Hüllkurve zu erhalten; einen Dominantes-Frequenzband-Identifizierungsabschnitt (301), der konfiguriert ist, ein oder mehrere dominante Frequenzbänder zu identifizieren, wobei ein dominantes Frequenzband ein Teilband ist, in dem die quantisierte Energiehüllkurve des Frequenzspektrums einen lokalen Maximalwert aufweist; einen Gruppenbestimmungsabschnitt (302-1, 302-N, 303), der konfiguriert ist, die quantisierten Teilbandenergien in eine Mehrzahl von Gruppen zu gruppieren, wobei der Gruppenbestimmungsabschnitt (302-1, 302-N, 303) konfiguriert ist, Gruppenbreiten der Mehrzahl von Gruppen gemäß Eingangssignalcharakteristika adaptiv zu bestimmen, und wobei der Gruppenbestimmungsabschnitt (302-1, 302-N, 303) konfiguriert ist, jedes dominante Frequenzband und Teilbänder auf beiden Seiten des dominanten Frequenzbands, die jeweils eine absteigende Neigung der quantisierten Energiehüllkurve bilden, als eine entsprechende dominante Gruppe zu bestimmen, und andere kontinuierliche Teilbänder als die eine oder die mehreren dominanten Gruppen als eine oder mehrere nicht dominante Gruppen zu bestimmen; einen ersten Bitzuordnungsabschnitt (308), der konfiguriert ist, jeder Gruppe der Mehrzahl von Gruppen Bits zuzuordnen, um für jede Gruppe der Mehrzahl von Gruppen eine gruppenspezifische Anzahl von Bits zu erhalten; einen zweiten Bitzuordnungsabschnitt (309), der konfiguriert ist, für jede Gruppe der Mehrzahl von Gruppen die gruppenspezifische Anzahl von Bits, die einer jeweiligen Gruppe der Mehrzahl von Gruppen zugeordnet sind, einer Mehrzahl von Teilbändern zuzuordnen, die zu der jeweiligen Gruppe gehören; einen Decodierabschnitt (205), der konfiguriert ist, für jedes Teilband der Mehrzahl von Teilbändern ein Frequenzspektrum eines Sprach- oder Audiosignals unter Verwendung der Bits, die dem jeweiligen Teilband zugeordnet sind, zu decodieren, um ein decodiertes Frequenzspektrum zu erhalten; einen Hüllkurvenformungsabschnitt (308), der konfiguriert ist, die dequantisierte spektrale Hüllkurve an das decodierte Frequenzspektrum anzulegen und ein decodiertes Spektrum zu reproduzieren; und einen Inverstransformationsabschnitt (209), der konfiguriert ist, das decodierte Spektrum von einem Frequenzbereich in einen Zeitbereich invers zu transformieren.

**19.** Die Sprach- oder Audiodecodiervorrichtung gemäß Anspruch 18, die ferner folgende Merkmale aufweist:

einen Energieberechnungsabschnitt (304), der konfiguriert ist, eine gruppenspezifische Energie zu berechnen; und einen Energievarianzberechnungsabschnitt (306), der konfiguriert ist, eine gruppenspezifische Energievarianz zu berechnen, wobei der erste Bitzuordnungsabschnitt (308) konfiguriert ist, basierend auf der berechneten gruppenspezifischen Energie und der gruppenspezifischen Energievarianz einer Gruppe mehr Bits zuzuordnen, wenn zumindest eine der Energie und der Energievarianz größer ist, und einer Gruppe weniger Bits zuzuordnen, wenn zumindest eine der Energie und der Energievarianz geringer ist.

**20.** Die Sprach- oder Audiodecodiervorrichtung gemäß Anspruch 18, bei der der zweite Bitzuordnungsabschnitt (309) konfiguriert ist, einem Teilband mit einer größeren Energiehüllkurve mehr Bits zuzuordnen und einem Teilband mit einer kleineren Energiehüllkurve weniger Bits zuzuordnen.

**21.** Ein Sprach- oder Audiocodierverfahren, das folgende Schritte aufweist:

Transformieren eines Eingangssignals von einem Zeitbereich in einen Frequenzbereich;
Schätzen einer Energiehüllkurve, die einen Energiepegel darstellt, für jedes Teilband einer Mehrzahl von Teilbändern, die durch Teilen eines Frequenzspektrums des Eingangssignals erhalten werden;
Quantisieren der Energiehüllkurve, um eine quantisierte Energiehüllkurve zu erhalten, die quantisierte Teilbandenergien für eine Mehrzahl von Teilbändern aufweist;
Identifizieren eines oder mehrerer dominanter Frequenzbänder, wobei ein dominantes Frequenzband ein Teilband ist, in dem die quantisierte Energiehüllkurve des Frequenzspektrums einen lokalen Maximalwert aufweist;
Gruppieren der quantisierten Teilbandenergien für die Mehrzahl von Teilbändern in eine Mehrzahl von Gruppen, wobei jede Gruppe eine Mehrzahl von zumindest zwei Teilbändern aufweist, wobei das Gruppieren adaptives Bestimmen von Gruppenbreiten der Mehrzahl von Gruppen gemäß Eingangssignalcharakteristika, Bestimmen jedes dominanten Frequenzbands und Teilbänder auf beiden Seiten des dominanten Frequenzbands, die jeweils eine absteigende Neigung der quantisierten Energiehüllkurve bilden, als eine entsprechende dominante Gruppe, und Bestimmen anderer kontinuierlicher Teilbänder als der einen oder mehreren dominanten Gruppen als eine oder mehrere nicht dominante Gruppen aufweist;
Zuordnen, für jede Gruppe der Mehrzahl von Gruppen, von Bits zu jeder Gruppe der Mehrzahl von Gruppen, um für jede Gruppe der Mehrzahl von Gruppen eine gruppenspezifische Anzahl von Bits zu erhalten;
Zuordnen, für jede Gruppe der Mehrzahl von Gruppen, der gruppenspezifischen Anzahl von Bits, die einer jeweiligen Gruppe der Mehrzahl von Gruppen zugeordnet sind, zu der Mehrzahl von Teilbändern, die zu der jeweiligen Gruppe gehören; und
Codieren, für jedes Teilband der Mehrzahl von Teilbändern, des Frequenzspektrums, das in dem jeweiligen Teilband enthalten ist, unter Verwendung von Bits, die dem jeweiligen Teilband zugeordnet sind.

**22.** Ein Sprach- oder Audiodecodierverfahren, das folgende Schritte aufweist:

Dequantisieren einer quantisierten spektralen Hüllkurve, die quantisierte Teilbandenergien aufweist, um eine dequantisierte spektrale Hüllkurve zu erhalten;
Identifizieren eines oder mehrerer dominanter Frequenzbänder, wobei ein dominantes Frequenzband ein Teilband ist, in dem die quantisierte Energiehüllkurve des Frequenzspektrums einen lokalen Maximalwert aufweist;
Gruppieren der quantisierten Teilbandenergien in eine Mehrzahl von Gruppen, wobei das Gruppieren adaptives Bestimmen von Gruppenbreiten der Mehrzahl von Gruppen gemäß Eingangssignalcharakteristika, Bestimmen jedes dominanten Frequenzbands und Teilbänder auf beiden Seiten des dominanten Frequenzbands, die jeweils eine absteigende Neigung der quantisierten Energiehüllkurve bilden, als eine entsprechende dominante Kurve, und Bestimmen anderer kontinuierlicher Teilbänder als der einen oder mehreren dominanten Gruppen als eine oder mehrere nicht dominante Gruppen aufweist;
Zuordnen, für jede Gruppe der Mehrzahl von Gruppen, von Bits zu jeder Gruppe der Mehrzahl von Gruppen, um für jede Gruppe der Mehrzahl von Gruppen eine gruppenspezifische Anzahl von Bits zu erhalten;
Zuordnen, für jede Gruppe der Mehrzahl von Gruppen, der gruppenspezifischen Anzahl von Bits, die einer jeweiligen Gruppe der Mehrzahl von Gruppen zugeordnet sind, zu einer Mehrzahl von Teilbändern, die zu der jeweiligen Gruppe gehören; und
Decodieren, für jedes Teilband der Mehrzahl von Teilbändern, eines Frequenzspektrums eines Sprach- oder Audiosignals unter Verwendung der Bits, die dem jeweiligen Teilband zugeordnet sind, um ein decodiertes Frequenzspektrum zu erhalten;
Anlegen der dequantisierten spektralen Hüllkurve an das decodierte Frequenzspektrum und Reproduzieren eines decodierten Spektrums; und
inverses Transformieren des decodierten Spektrums von einem Frequenzbereich in einen Zeitbereich.

**23.** Funkkommunikationsendgerätvorrichtung, Funkkommunikationsbasisstationsvorrichtung, Telefonkonferenzendgerätvorrichtung, Videokonferenzendgerätvorrichtung oder Internet-Protokoll-Telefonie(VoIP)-Endgerätvorrichtung, die eine Sprach- oder Audiocodiervorrichtung gemäß Anspruch 1 oder eine Sprach- oder Audiodecodiervorrichtung gemäß Anspruch 18 aufweist.

**Revendications**

**1.** Appareil de codage de parole ou audio comprenant:

un segment de transformation (102) configuré pour transformer un signal d'entrée d'un domaine temporel à un domaine de la fréquence;

un segment d'estimation (103) configuré pour estimer une enveloppe d'énergie qui représente un niveau d'énergie pour chaque sous-bande d'une pluralité de sous-bandes obtenues en divisant un spectre de fréquence du signal d'entrée;

un segment de quantification (104) configuré pour quantifier l'enveloppe d'énergie pour obtenir une enveloppe d'énergie quantifiée comprenant les énergies de sous-bande quantifiées pour la pluralité de sous-bandes;

un segment d'identification de bande de fréquence dominante (301) configuré pour identifier une ou plusieurs bandes de fréquence dominantes, une bande de fréquence dominante étant une sous-bande dans laquelle l'enveloppe d'énergie quantifiée du spectre de fréquence présente une valeur maximale locale,

un segment de détermination de groupe (302-1, 302-N, 303) configuré pour regrouper les énergies de sous-bande quantifiées en une pluralité de groupes, où le segment de détermination de groupe (302-1, 302-N, 303) est configuré pour déterminer de manière adaptative les largeurs de groupe de la pluralité de groupes selon les caractéristiques du signal d'entrée, et où le segment de détermination de groupe (302-1, 302-N, 303) est configuré pour déterminer chaque bande de fréquence dominante et les sous-bandes des deux côtés de la bande de fréquence dominante formant, chacune, une pente descendante de l'enveloppe d'énergie quantifiée comme un groupe dominant correspondant et pour déterminer les sous-bandes continues autres que les un ou plusieurs groupes dominants comme un ou plusieurs groupes non dominants;

un premier segment d'attribution de bits (308) configuré pour attribuer des bits à chaque groupe de la pluralité de groupes pour obtenir un nombre de bits spécifique au groupe pour chaque groupe de la pluralité de groupes;

un deuxième segment d'attribution de bits (309) configuré pour attribuer, pour chaque groupe de la pluralité de groupes, le nombre de bits spécifique au groupe attribués à un groupe respectif de la pluralité de groupes à la pluralité de sous-bandes appartenant au groupe respectif; et

un segment de codage (108) configuré pour coder, pour chaque sous-bande de la pluralité de sous-bandes, le spectre de fréquence dans la sous-bande respective à l'aide des bits attribués à la sous-bande respective.

2. Appareil de codage de parole ou audio selon la revendication 1, comprenant par ailleurs:

un segment de calcul d'énergie (304) configuré pour calculer une énergie spécifique au groupe; et

un segment de calcul de variance d'énergie (306) configuré pour calculer une variance d'énergie spécifique au groupe,

dans lequel

le premier segment d'attribution de bits (308) est configuré pour attribuer, sur base de l'énergie spécifique au groupe calculée et de la variance d'énergie spécifique au groupe, plus de bits à un groupe lorsqu'au moins l'une parmi l'énergie et la variance d'énergie est supérieure et pour attribuer moins de bits à un groupe lorsqu'au moins l'une parmi l'énergie et la variance d'énergie est inférieure.

3. Appareil de codage de parole ou audio selon la revendication 1, dans lequel le deuxième segment d'attribution de bits (309) est configuré pour attribuer plus de bits à une sous-bande présentant une plus grande enveloppe d'énergie et attribuer moins de bits à une sous-bande présentant une plus petite enveloppe d'énergie.

4. Appareil de codage de parole ou audio selon la revendication 1, dans lequel le deuxième segment d'attribution de bits (309) est configuré pour attribuer plus de bits à une sous-bande perceptuellement plus importante et moins de bits à une sous-bande perceptuellement moins importante.

5. Appareil de codage de parole ou audio selon la revendication 1, dans lequel le deuxième segment d'attribution de bits (309) est configuré pour attribuer plus de bits aux sous-bandes dans un groupe présentant une variance d'énergie supérieure et pour attribuer moins de bits aux sous-bandes dans un groupe présentant une variance d'énergie inférieure.

6. Appareil de codage de parole ou audio selon la revendication 1, dans lequel le deuxième segment d'attribution de bits (309) est configuré pour attribuer plus de bits aux sous-bandes dans un groupe présentant une crête dans le spectre de fréquence et pour attribuer moins de bits aux sous-bandes dans un groupe présentant un creux dans le spectre de fréquence.

7. Appareil de codage de parole ou audio selon la revendication 1, dans lequel le deuxième segment d'attribution de bits (309) est configuré pour fonctionner sur base de l'équation suivante:

$$Bits_{G(k)sb(i)} = Bits(G(k)) \times \frac{Norm(i)}{Energy(G(k))} ,$$

où $Bits_{G(k)sb(i)}$ désigne un bit attribué à une sous-bande i d'un groupe k, i désigne un indice de sous-bande du groupe k, $Bits_{(G(k))}$ désigne un bit attribué au groupe k, Energy(G(k)) désigne une énergie du groupe k, et Norm(i) désigne une valeur d'énergie de sous-bande de la sous-bande i du groupe k.

8. Appareil de codage de parole ou audio selon la revendication 1, dans lequel le premier segment d'attribution de bits (308) est configuré pour attribuer plus de bits à un groupe dominant et moins de bits à un groupe non dominant.

9. Appareil de codage de parole ou audio selon la revendication 1, dans lequel le premier segment d'attribution de bits (308) est configuré pour attribuer des bits par groupe sur base d'une énergie spécifique au groupe calculée par un segment de calcul d'énergie de groupe (304), d'une énergie totale de tous les groupes calculée par un segment de calcul d'énergie totale (305), d'une variance d'énergie spécifique au groupe calculée par un segment de calcul de variance de norme (306) et d'une variance d'énergie totale de tous les groupes calculée par un segment de calcul de variance de norme totale (307).

10. Appareil de codage de parole ou audio selon la revendication 9, dans lequel le premier segment d'attribution de bits (308) est configuré pour fonctionner sur base de l'équation suivante:

$$Bits(G(k)) = Bits_{total} \times \left( scale1 \times \frac{Energy(G(k))}{Energy_{total}} + (1 - scale1) \times \frac{Norm_{var}(G(k))}{Norm_{var\,total}} \right) ,$$

où k désigne un indice de chaque groupe, Bits(G(k)) désigne un nombre de bits attribués à un groupe k, $Bits_{total}$ désigne un nombre total de bits disponibles, scale1 ajuste un rapport de bits attribués par énergie, Energy(G(k)) désigne l'énergie spécifique au groupe du groupe k, $Energy_{total}$ désigne l'énergie totale de tous les groupes, Normvar(G(k)) désigne la variance d'énergie spécifique au groupe du groupe k, et $Norm_{vartotal}$ désigne la variance d'énergie totale de tous les groupes.

11. Appareil de codage de parole ou audio selon la revendication 10, dans lequel une valeur de scale 1 est comprise entre 0 et 1.

12. Appareil de codage de parole ou audio selon la revendication 1, dans lequel le premier segment d'attribution de bits (308) est configuré pour déterminer une importance perceptuelle de chaque groupe à l'aide d'une énergie et d'une variance d'énergie du groupe et pour améliorer davantage un groupe dominant par rapport à un groupe non dominant.

13. Appareil de codage de parole ou audio selon la revendication 1, dans lequel le premier segment d'attribution de bits (308) est configuré pour déterminer une importance perceptuelle d'un groupe sur base d'une énergie du groupe et d'une répartition d'énergie et pour déterminer les bits à attribuer à chaque groupe sur base de l'importance perceptuelle pour le groupe respectif.

14. Appareil de codage de parole ou audio selon la revendication 1, dans lequel le segment de détermination de groupe (302-1, 302-N, 303) est configuré pour inclure, lorsqu'une bande de fréquences dominante se situe à une extrémité d'une fréquence disponible, uniquement un côté de la pente descendante dans le groupe correspondant.

15. Appareil de codage de parole ou audio selon la revendication 1, dans lequel le segment de détermination de groupe (302-1, 302-N, 303) est configuré pour séparer les crêtes du spectre de fréquence des creux du spectre de fréquence, dans lequel une crête du spectre de fréquence se situe dans un groupe dominant et un creux du spectre de fréquence se situe dans un groupe non dominant.

16. Appareil de codage de parole ou audio selon la revendication 1,

dans lequel le premier segment d'attribution de bits (308) est configuré pour attribuer les bits à un groupe respectif sur base d'une énergie du groupe respectif et d'une variance d'énergie du groupe respectif, et

dans lequel le deuxième segment d'attribution de bits (309) est configuré pour attribuer les bits, attribués par groupe au groupe respectif, à une sous-bande respective dans le groupe respectif selon un rapport entre une énergie de la sous-bande respective et une énergie du groupe respectif.

17. Appareil de codage de parole ou audio selon la revendication 1,

dans lequel le premier segment d'attribution de bits (308) est configuré pour attribuer plus de bits à un groupe perceptuellement plus important et moins de bits à un groupe perceptuellement moins important, et
dans lequel le deuxième segment d'attribution de bits (309) est configuré pour attribuer plus de bits à une sous-bande perceptuellement plus importante et moins de bits à une sous-bande perceptuellement moins importante.

18. Appareil de décodage de parole ou audio comprenant:

un segment de déquantification (202) configuré pour déquantifier une enveloppe spectrale quantifiée comprenant les énergies de sous-bande quantifiées pour obtenir une enveloppe spectrale déquantifiée;
un segment d'identification de bande de fréquences dominante (301) configuré pour identifier une ou plusieurs bandes de fréquences plus dominantes, une bande de fréquences dominante étant une sous-bande dans laquelle l'enveloppe d'énergie quantifiée du spectre de fréquence présente une valeur maximale locale;
un segment de détermination de groupe (302-1, 302-N, 303) configuré pour regrouper les énergies de sous-bande quantifiées en une pluralité de groupes, où le segment de détermination de groupe (302-1, 302-N, 303) est configuré pour déterminer de manière adaptative les largeurs de groupe de la pluralité de groupes selon les caractéristiques du signal d'entrée, et où le segment de détermination de groupe (302-1, 302-N, 303) est configuré pour déterminer chaque bande de fréquence dominante et les sous-bandes des deux côtés de la bande de fréquence dominante formant, chacune, une pente descendante de l'enveloppe d'énergie quantifiée comme un groupe dominant correspondant et pour déterminer les sous-bandes continues autres que les un ou plusieurs groupes dominants comme un ou plusieurs groupes non dominants;
un premier segment d'attribution de bits (308) configuré pour attribuer des bits à chaque groupe de la pluralité de groupes pour obtenir un nombre de bits spécifique au groupe pour chaque groupe de la pluralité de groupes;
un deuxième segment d'attribution de bits (309) configuré pour attribuer, pour chaque groupe de la pluralité de groupes, le nombre de bits spécifique au groupe attribués à un groupe respectif de la pluralité de groupes à une pluralité de sous-bandes appartenant au groupe respectif;
un segment de décodage (205) configuré pour décoder, pour chaque sous-bande de la pluralité de sous-bandes, un spectre de fréquence d'un signal de parole ou audio à l'aide des bits attribués à la sous-bande respective pour obtenir un spectre de fréquence décodé;
un segment de mise en forme d'enveloppe (208) configuré pour appliquer l'enveloppe spectrale déquantifiée au spectre de fréquence décodé et pour reproduire un spectre décodé; et
un segment de transformation inverse (209) configuré pour transformer inversement le spectre décodé d'un domaine de la fréquence à un domaine temporel.

19. Appareil de décodage de parole ou audio selon la revendication 18, comprenant par ailleurs:

un segment de calcul d'énergie (304) configuré pour calculer une énergie spécifique au groupe; et
un segment de calcul de variance d'énergie (306) configuré pour calculer une variance d'énergie spécifique au groupe,
dans lequel
le premier segment d'attribution de bits (308) est configuré pour attribuer, sur base de l'énergie spécifique au groupe calculée et de la variance d'énergie spécifique au groupe, plus de bits à un groupe lorsqu'au moins l'une parmi l'énergie et la variance d'énergie est supérieure et pour attribuer moins de bits à un groupe lorsqu'au moins l'une parmi l'énergie et la variance d'énergie est inférieure.

20. Appareil de décodage de parole ou audio selon la revendication 18, dans lequel le deuxième segment d'attribution de bits (309) est configuré pour attribuer plus de bits à une sous-bande présentant une plus grande enveloppe d'énergie et pour attribuer moins de bits à une sous-bande présentant une plus petite enveloppe d'énergie.

21. Procédé de codage de parole ou audio comprenant le fait de:

transformer un signal d'entrée d'un domaine temporel à un domaine de la fréquence;
estimer une enveloppe d'énergie qui représente un niveau d'énergie pour chaque sous-bande d'une pluralité de sous-bandes obtenues en divisant un spectre de fréquence du signal d'entrée;

quantifier l'enveloppe d'énergie pour obtenir une enveloppe d'énergie quantifiée comprenant les énergies de sous-bande quantifiées pour une pluralité de sous-bandes;

identifier une ou plusieurs bandes de fréquences dominantes, une bande de fréquences dominante étant une sous-bande dans laquelle l'enveloppe d'énergie quantifiée du spectre de fréquence présente une valeur maximale locale;

regrouper les énergies de sous-bande quantifiées pour la pluralité de sous-bandes en une pluralité de groupes, chaque groupe présentant une pluralité d'au moins deux sous-bandes, où le regroupement comprend le fait de déterminer de manière adaptative les largeurs de groupe de la pluralité de groupes selon les caractéristiques du signal d'entrée, déterminer chaque bande de fréquence dominante et les sous-bandes des deux côtés de la bande de fréquence dominante formant, chacune, une pente descendante de l'enveloppe d'énergie quantifiée comme groupe dominant correspondant, et déterminer les sous-bandes continues autres que les un ou plusieurs groupes dominants comme un ou plusieurs groupes non dominants;

attribuer, pour chaque groupe de la pluralité de groupes, des bits à chaque groupe de la pluralité de groupes pour obtenir un nombre de bits spécifique au groupe pour chaque groupe de la pluralité de groupes;

attribuer, pour chaque groupe de la pluralité de groupes, le nombre de bits spécifique au groupe attribué à un groupe respectif de la pluralité de groupes à la pluralité de sous-bandes appartenant au groupe respectif; et

coder, pour chaque sous-bande de la pluralité de sous-bandes, le spectre de fréquence inclus dans la sous-bande respective à l'aide des bits attribués à la sous-bande respective.

22. Procédé de décodage de parole ou audio comprenant le fait de:

déquantifier une enveloppe spectrale quantifiée comprenant les énergies de sous-bande quantifiées pour obtenir une enveloppe spectrale déquantifiée;

identifier une ou plusieurs bandes de fréquences dominantes, une bande de fréquences dominante étant une sous-bande dans laquelle l'enveloppe d'énergie quantifiée du spectre de fréquence présente une valeur maximale locale;

regrouper les énergies de sous-bande quantifiées en une pluralité de groupes, où le regroupement comprend le fait de déterminer de manière adaptative les largeurs de groupe de la pluralité de groupes selon les caractéristiques du signal d'entrée, déterminer chaque bande de fréquences dominante et les sous-bandes des deux côtés de la bande de fréquences dominante formant, chacune, une pente descendante de l'enveloppe d'énergie quantifiée comme un groupe dominant correspondant, et déterminer les sous-bandes continues autres que les un ou plusieurs groupes dominants comme un ou plusieurs groupes non dominants;

attribuer, pour chaque groupe de la pluralité de groupes, des bits à chaque groupe de la pluralité de groupes pour obtenir un nombre de bits spécifique au groupe pour chaque groupe de la pluralité de groupes;

attribuer, pour chaque groupe de la pluralité de groupes, le nombre de bits spécifique au groupe attribués à un groupe respectif de la pluralité de groupes à une pluralité de sous-bandes appartenant au groupe respectif;

décoder, pour chaque sous-bande de la pluralité de sous-bandes, un spectre de fréquence d'un signal de parole ou audio à l'aide des bits attribués à la sous-bande respective pour obtenir un spectre de fréquence décodé;

appliquer l'enveloppe spectrale déquantifiée au spectre de fréquence décodé et reproduire un spectre décodé; et

transformer de manière inverse le spectre décodé d'un domaine de la fréquence à un domaine temporel.

23. Appareil terminal de radiocommunication, appareil de station de base de radiocommunication, appareil terminal de conférence téléphonique, appareil terminal de vidéoconférence ou appareil terminal de parole par protocole Internet (VoIP) comprenant un appareil de codage de parole ou audio selon la revendication 1, ou un appareil de décodage de parole ou audio selon la revendication 18.

*FIG. 1*

FIG. 2

| GROUP | LENGTH OF SUB-VECTOR | NUMBER OF SUB-VECTORS | NUMBER OF COEFFICIENTS | BAND WIDTH (Hz) | START (Hz) | END (Hz) |
|-------|-----------------------|-------------------------|--------------------------|-------------------|--------------|------------|
| I     | 8                     | 16                      | 128                      | 3 200             | 0            | 3 200      |
| II    | 16                    | 8                       | 128                      | 3 200             | 3 200        | 6 400      |
| III   | 24                    | 12                      | 288                      | 7 200             | 6 400        | 13 600     |
| IV    | 32                    | 8                       | 256                      | 6 400             | 13 600       | 20 000     |
| TOTAL |                       | 44                      | 800                      | 20 000            |              |            |

## FIG. 3

START

NORM ADJUSTMENT — ST31

IDENTIFY SUBBAND
HAVING MAXIMUM NORM — ST32

ALLOCATE BITS
TO SUBBANDS — ST33

NORM OF
SUBBAND REDUCED — ST34

IS NUMBER OF
ALLOCATABLE BITS
EQUAL TO OR
ABOVE 8? — ST35

YES

NO

END

FIG. 4

FIG. 5

FIG. 6

*FIG. 7*

107

QUANTIZED SPECTRAL ENVELOPE

301 DOMINANT FREQUENCY BAND IDENTIFICATION SECTION

302-1 DOMINANT GROUP DETERMINING SECTION

302-N DOMINANT GROUP DETERMINING SECTION

303 NON-DOMINANT GROUP DETERMINING SECTION

305 TOTAL ENERGY CALCULATION SECTION

304 GROUP ENERGY CALCULATION SECTION

306 NORM VARIANCE CALCULATION SECTION

307 TOTAL NORM VARIANCE CALCULATION SECTION

308 GROUP BIT DISTRIBUTION SECTION

309 SUBBAND BIT DISTRIBUTION SECTION

BIT ALLOCATION RESULT

FIG. 8A

FIG. 8B

FIG. 8C

FIG. 9

**EP 3 457 400 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012004918 A1

- EP 0259553 A2

**Non-patent literature cited in the description**

- Low-complexity full-band audio coding for high-quality conversational applications. *ITU-T Recommendation G.719,* 2009

- Low Complexity coding at 24 and 32 kbit/s for hands-free operation in systems with low frame loss. *TD 47 (WP316), ITU-T Draft Study Period 2005-2008,* 08 April 2005, vol. 10-16, 1-37